## Europäisches Patentamt

## European Patent Office

## Office européen des brevets

(19)

(11) Veröffentlichungsnummer: **0 012 862**
**A2**

(12)

# EUROPÄISCHE PATENTANMELDUNG

(21) Anmeldenummer: **79104723.6**

(22) Anmeldetag: **27.11.79**

(51) Int. Cl.³: **C 23 C 3/00**

(30) Priorität: **20.12.78 US 971125**

(43) Veröffentlichungstag der Anmeldung:
**09.07.80 Patentblatt 80/14**

(84) Benannte Vertragsstaaten:
**DE FR GB**

(71) Anmelder: **International Business Machines Corporation**

**Armonk, N.Y. 10504(US)**

(72) Erfinder: **Acitelli, Mario Adam**
**2913 Holly Lane**
**Endwell, New York 13760(US)**

(72) Erfinder: **Woods, James John**
**Smith Road**
**Binghamton, New York 13905(US)**

(74) Vertreter: **Kreidler, Eva-Maria, Dr. rer. nat.**
**Schönaicher Strasse 220**
**D-7030 Böblingen(DE)**

(54) **Verfahren zur stromlosen Metallisierung einer isolierenden Unterlage.**

(57) Die Erfindung betrifft ein Verfahren zur stromlosen Metallisierung einer isolierenden Unterlage.

In dem erfindungsgemäßen Verfahren wird auf ein mit einem ungehärteten Epoxidharz imprägnierten Laminat aus Glasfasergewebe eine Klebstoffschicht aufgetragen. Die Klebstoffschicht, die im wesentlichen aus einem ungehärteten Nitrilkautschuk/Phenolkunstharzkleber besteht, wird zuerst auf einem Übertragungsblatt angeordnet. Die Oberfläche der Klebstoffschicht wird mit der isolierenden Unterlage in Kontakt gebracht und durch Anwendung von Hitze und Druck ausgehärtet. Nach dem Aushärten wird das Übertragungsblatt abgeschält und auf der Kunstharzklebeschicht in an sich bekannter Weise durch stromloses Plattieren eine Metallschicht abgeschieden.

Durch die gemeinsame Härtung des Epoxidharzes, mit dem die Unterlage imprägniert ist und des Kunstharzklebers wird die Klebeschicht mit der Unterlage integral verbunden. Trotz der niedrigen Schichtdicke der Klebeschicht werden außerordentlich hohe Bindefestigkeiten erhalten.

EP 0 012 862 A2

Croydon Printing Company Ltd.

Verfahren zur stromlosen Metallisierung einer isolierenden Unterlage

Die Erfindung betrifft ein Verfahren zur stromlosen Metallisierung einer isolierenden Unterlage. Die stromlose Metallisierung isolierender Unterlagen wird insbesondere zur Herstellung gedruckter Schaltkreise angewendet.

Es ist allgemein bekannt, Unterlagen aus einer Vielzahl von fasrigen Blättern oder Vliesen, die mit einem hitzehärtbaren Harz, üblicherweise mit einem Epoxidharz imprägniert sind, als Basis zu verwenden und auf dieser zur Herstellung gedruckter Schaltkreisplatten mittels stromloser Metallisierung eine festhaftende Metallschicht oder ein Muster zu erzeugen. Es ist auch bekannt, daß vor der stromlosen Metallisierung oder diese vorbereitenden Schritten (Ätzen, Sensibilisieren und dgl.) die Unterlage Hitze- und Druckbedingungen ausgesetzt wird, um das hitzehärtbare Harz zur Ausbildung eines gehärteten integralen Laminats zu härten und auf diesem oder in diesem gedruckte Schaltkreise zu bilden.

Nachfolgend wird das mit einem hitzehärtbaren Harz imprägnierte Fasermaterial, dessen Harzanteil noch nicht gehärtet wurde, als isolierende Unterlage bezeichnet. Nach dem Härten wird das Material als gehärtete isolierende Unterlage bezeichnet.

Bisher traten Schwierigkeiten auf bei der Ausbildung einer festen Bindung zwischen der Oberfläche der gehärteten isolierenden Unterlage und einer stromlos abgeschiedenen Metallschicht. Abschälfestigkeiten in der Größenordnung von 5,49 bis 6,87 N/cm$^2$ (8 bis 10 pounds/square inch) oder höher sind als Bindefestigkeit erwünscht, aber schwierig zu erreichen. Ein Vorschlag zur Verbesserung der Bindefestig-

- 2 -

keit zwischen der Oberfläche eines gehärteten isolierenden Materials und einer stromlos darauf abgeschiedenen Metallschicht betraf die intermediäre Anordnung einer Kunststoffklebeschicht vor der stromlosen Metallisierung oder diese vorbereitenden Schritten. Bisher wurde eine Kunststoffklebeschicht in einem wenigstens teilweise gehärteten Zustand von einem Übertragungsmaterial auf die Oberfläche der isolierenden Unterlage übertragen, und anschließend wurde das Übertragungsmaterial entfernt und die beschichtete isolierende Unterlage in bekannter Weise unter Ausbildung einer gehärteten isolierenden Unterlage laminiert. Wenn der Kunststoffkleber vor der Übertragung nicht vollständig ausgehärtet war, wurde die Härtung unter den Hitze- und Druckbedingungen der Laminierung, d. h. für mit Phenolharzen imprägnierte Unterlagen während 45 Minuten, 171° C und 689,64 bis 1034,95 N/cm$^2$ (1000 bis 1500 psi) und für mit Epoxidharzen imprägnierte Unterlagen während 1/4 bis 1/2 Stunde bei 171° C und 138,32 bis 189,33 N/cm$^2$ (200 bis 275 psi) durchgeführt.

In der US-Patenschrift 3 956 041 ist ein Übertragungsverfahren beschrieben, bei dem eine Metallfolie oder ein Kunststoffübertragungsblatt mit einer Klebstoffzusammensetzung, welche teilweise bis zum "B"-Zustand ausgehärtet wurde unter Erhalt einer lösungsmittelfreien, nichtklebrigen und nicht vollständig gehärteten Oberfläche, beschichtet wurde. Klebstoffe wie Nitrilkautschuk und hitzehärtbare Phenolharze wurden in Betracht gezogen. Die mit dem Klebstoff beschichtete Oberfläche des Übertragungsmaterials wird mit der Oberfläche der isolierenden Unterlage in Kontakt gebracht. Nachdem das Laminat üblichen Hitze- und Druckbedingungen ausgesetzt war, wurde das Übertragungsbasismaterial entfernt, beispielsweise durch Abschälen, und dann wird die stromlose Metallisierung durchgeführt.

In den US-Patentschriften 3 925 138 und 4 001 460 werden

EN 978 017

Verfahren beschrieben, die in bestimmten Ausführungsbeispielen dem in der US-Patentschrift 3 956 041 beschriebenen Verfahren ähnlich sind, mit der Ausnahme, daß der Klebstoff auf dem Übertragungsmaterial und vor der Laminierung vollständig ausgehärtet wurde.

Bisher wurden als Basismaterialien zur Übertragung Papier, Kunststoffilme, Metallfolien und dgl. angewendet. Im allgemeinen wird das Übertragungsbasismaterial so ausgewählt, daß es von dem Laminat nach Einwirkung von Hitze und Druck abgeschält werden kann. Wird jedoch eine Metallfolie als Basis des Übertragungsmaterials verwendet, dann wird die Anwendung eines Trennmittels zur Erleichterung des Abschälens bevorzugt, oder die Metallfolie wird nach der Verdichtung abgeätzt (aufgelöst). In diesem Zusammenhang wird auf die US-Patentschriften 3 925 138 und 3 948 701 verwiesen. In der US-Patentschrift 3 948 701 wird auch bis zu einem gewissen Grad eine vorläufige Härtung im Falle der Härtung nach dem Kondensationsmechanismus durch Kondensation des Klebstoffs auf dem Übertragungsbasis- oder Trägermaterial vor der Laminierung mit der isolierenden Unterlage durchgeführt.

MacDermid Inc., Waterbury, Connecticut vertreibt im Handel Produkte unter dem Warenzeichen Pladd II. Es wird angenommen, daß eines dieser Produkte eine Metallfolie ist, auf der ein gehärtetes Harz angeordnet ist. Das Produkt ist zur Anordnung auf einer Unterlage bei der Herstellung gedruckter Schaltkreisplatten vorgesehen. Die Folie muß nach dem Laminierungsschritt abgeätzt werden.

Aufgabe der Erfindung ist die Bereitstellung eines verbesserten Verfahrens zur stromlosen Metallisierung, bei dem eine verbesserte, mit Klebstoff beschichtete, gehärtete isolierende Unterlage, die zur Herstellung gedruckter

EN 978 017

- 4 -

Schaltkreisplatten geeignet ist, verwendet wird. Auf dieser kann eine festhaftende Metallschicht mittels stromloser Metallisierung erzeugt werden.

Die Aufgabe der Erfindung wird gelöst durch ein Verfahren, das durch Patentanspruch 1 gekennzeichnet ist.

Vorteilhafte Ausgestaltungen der Erfindung sind in den Unteransprüchen niedergelegt.

Nach dem erfindungsgemäßen Verfahren kann eine gehärtete isolierende Unterlage, die zur Herstellung gedruckter Schaltkreise verwendet wird, hergestellt werden, die eine Klebstoffschicht als integralen Bestandteil enthält, auf der mittels konventioneller stromloser Metallisierung eine Metallschicht abgeschieden werden kann mit einer Bindekraft in der Größenordnung von 5,49 bis 6,87 N/cm$^2$ (8 bis 10 psi) zwischen der abgeschiedenen Metallschicht und der Unterlage, die wesentlich höher ist als die nach bisherigen Verfahren erhaltene Bindekraft. Ein weiterer Vorteil ist, daß mit dem erfindungsgemäßen Verfahren eine verbesserte gehärtete Unterlage hergestellt werden kann, bei der die Unterlage mit einer sehr dünnen Klebharzschicht beschichtet wird unter gleichzeitigem Erhalt einer hohen Bindekraft der stromlos abgeschiedenen Metallschicht.

Die Erfindung wird nachfolgend anhand der speziellen Beschreibung und eines Ausführungsbeispiels näher erläutert.

Die zuvor angegebenen Vorteile der Erfindung werden erhalten, wenn ein Übertragungsmaterial, das mit einem Überzug aus einem im wesentlichen lösungsmittelfreien nicht gehärteten, aber hitzehärtbaren Nitrilkautschuk/Phenolharzkleber beschichtet ist, mit der Klebharzschicht nach unten auf eine isolierende Unterlage laminiert und anschließend das

EN 978 017

Übertragungsmaterial von dem Laminat entfernt wird. In bevorzugten Ausführungsformen der Erfindung ist das Klebharz eine Mischung aus einem hitzehärtbaren Phenolharz und einem Butadien-Acrylnitril-Kautschukpolymeren, und die isolierende Unterlage ist mit einem vollständig oder teilweise gehärteten Epoxidharz, d. h., es wurde höchstens eine Härtung bis zur "B"-Stufe durchgeführt, imprägniert. Das Übertragungsmaterial ist vorzugsweise ein Kunststoffilm, der von der Klebstoffschicht nach der Härtung der Kompositstruktur abgeschält werden kann.

Wie in den Ausführungen zum Stand der Technik angegeben, wurden bisher Nitrilkautschuk/Phenolharzklebstoffe mindestens im Zustand der "B"-Stufenhärtung mittels eines Übertragungsfilms auf die Oberfläche einer isolierenden Unterlage, die für die Verwendung als gedruckte Schaltkarte geeignet ist, aufgetragen. Die vorliegende Erfindung betrifft eine Verbesserung dieses Standes der Technik. Deshalb kann die isolierende Unterlage, der Nitrilharz/Phenolharzklebstoff und der Übertragungs- oder Trägerfilm entsprechend dem Stand der Technik beschrieben werden.

Die isolierende Unterlage ist üblicherweise ein laminiertes Material aus mehreren Schichten von Glasfasergewebe, das mit einem hitzehärtbaren Harz imprägniert ist. Hitzehärtbare Phenol- und Epoxidharze sind bekannt. Im Rahmen der vorliegenden Erfindung wird, wie nachfolgend diskutiert wird, ein Epoxidharz bevorzugt. Es ist wesentlich, daß im Rahmen der vorliegenden Erfindung ein hitzehärtbares Harz, welches höchstens bis zur "B"-Stufe gehärtet ist, verwendet wird. Dies ermöglicht, zumindest theoretisch, eine Wechselwirkung zwischen dem hitzehärtbaren Harz und dem nachfolgend aufzutragenden Kunstharzkleber. Vorzugsweise wird das hitzehärtbare Harz der isolierenden Unterlage auf das Glasfasergewebelaminat aus flüssigem Zustand aufgetragen und bei einer Temperatur getrocknet, die unter derjenigen liegt, bei der irgendeine Reaktion zwischen den Komponenten stattfindet. Dies kann routinemäßig durch chemische Analyse, beispielsweise durch Infrarot-Spektrophotometrie oder Differentialcolorimetrie festgestellt werden.

Die Nitrilkautschuk/Phenolharzklebstoffe sind bekannt und im Handel erhältlich. Die Klebstoffharze umfassen ein Nitrilcopolymer und ein hitzehärtbares Phenolharz. Im allgemeinen ist das Nitrilcopolymere ein Acrylnitril/Butadien-Copolymer, das als Nitrilkautschuk bezeichnet wird. Eine andere Möglichkeit wäre, ein drittes Comonomer, beispielsweise Styrol einzuschließen, d. h. ein Acrylnitril/Butadien/Styrol-Terpolymer zu verwenden. In gleicher Weise sind die hitzehärtbaren Phenolharze gut bekannt, beispielsweise diejenigen, die zur Imprägnierung der Glasfasergewebelaminate verwendet werden und brauchen deshalb nicht näher beschrieben zu werden. Ein im Handel erhältlicher Klebstoff ist BR-238, ein Nitril/Phenol-Kunstharzkleber, welcher von der American Cyanamid, Harve de Grace, Maryland hergestellt wird.

Wie zuvor angegeben, wird eine mit Epoxidharz imprägnierte isolierende Unterlage zur Beschichtung mit dem Nitril/Phenolharzklebstoff bevorzugt. Dieses erfolgt, weil extrem starke Bindungen gebildet werden. Der Klebstoff wird während des Härt- und Laminierzyklus durch Einwirkung von Hitze und Druck integraler Bestandteil der gehärteten isolierenden Unterlage. Tatsächlich wird der Klebstoff auf die isolierende Unterlage übertragen und härtet zusammen mit dem Epoxidharz aus. Es wird angenommen, daß während dieses gegenseitigen Härtens, welches Kondensations- und Vernetzungsreaktionen umfaßt, die aktiven Wasserstoffatome des Klebstoffs, welche von -OH, -NH, und dgl. geliefert werden, mit den Oxiranringen des Epoxidharzes reagieren und so integraler Bestandteil der gehärteten isolierenden Unterlage

EN 978 017

werden. Es wurde experimentell bestimmt, daß BR-238 bei Temperaturen von oder unter 65,6$^O$ C nicht aushärtet, auch nicht zu einer "B"-Stufe. Daher sollte, wenn dieses spezielle Material verwendet wird, dieses nicht Temperaturen über 65,6$^O$ C ausgesetzt werden, ehe es mit der isolierenden Unterlage in Kontakt gebracht wird. Durch Anwendung von Infrarot-Spektrophotometrie und Differentialcolorimetrie kann der Fachmann die Maximaltemperatur bestimmen, der ein hitzehärtbarer Nitrilkautschuk/Phenolharzkleber ausgesetzt werden kann, ohne daß eine Härtung stattfindet.

Das Übertragungsmaterial oder Trägerblatt gemäß der Erfindung wird ausgewählt aus beschichteten Papieren, Kunststoffblättern und Metallfolien. Vorzugsweise wird ein Kunststoffblatt angewendet, beispielsweise aus Polyäthylen, Polyvinylchlorid, Polyvinylfluorid, Polyester, Polypropylen, Polyoxymethylen und dgl. Derzeit ist ein bevorzugtes Übertragungsmaterial ein Polyvinylfluoridfilm, der unter dem Warenzeichen Tedlar von DuPont erhältlich ist.

Das Übertragungsmaterial wird vorzugsweise so ausgewählt, daß es von der gehärteten isolierenden Unterlage abgeschält werden kann. Es wird angenommen, daß jedes der oben angegebenen Übertragungsmaterialien verwendet werden kann, wobei manchmal ein Trennmittel wie ein Siliconharz angewendet werden muß, um die Entfernung zu erleichtern. Darüber hinaus kann die Entfernung, insbesondere bei Metallfolien, durch an sich bekannte Ätzverfahren erfolgen.

Der Klebstoff kann auf das Übertragungsmaterial in einem konventionellen Verfahren aufgetragen werden. Er wird im allgemeinen in Form einer Lösung in einem flüchtigen Lösungsmittel oder einer Suspension, beispielsweise unter Anwendung einer Ziehstange, durch Aufsprühen, Tauchen, mittels einer Rakel, durch Fließbeschichten oder dgl. aufgetragen. Das flüchtige Lösungsmittel soll mit dem Klebstoff nicht reagieren und muß aus demselben bei einer Temperatur entfernbar sein, die unter der Härtetemperatur des Klebstoffs liegt. Als Beispiel kann Methyläthylketon als flüchtiges Lösungsmittel verwendet werden, welches nach dem Auftrag der Klebstoffbeschichtung auf das Übertragungsmaterial bei etwa 65,6° C abgezogen wird. Die Anwendung anderer Lösungsmittel sind dem Fachmann geläufig, beispielsweise Methylisobutylketon, Benzol, Aceton und Mischungen der Lösungsmittel.

Ein Vorteil der vorliegenden Erfindung ist, daß ein extrem dünner Klebstoffilm verwendet werden kann unter Erhalt außergewöhnlich hoher Bindekräfte. Beispielsweise kann die Schichtdicke des Klebstoffs, der auf die isolierende Unterlage aufgetragen wird, vor dem Härten etwa 0,0076 bis 0,021 mm betragen.

Wenn das Übertragungsmaterial, welches mit dem Klebstoff beschichtet ist, auf die isolierende Unterlage laminiert ist, wird die Kompositstruktur gehärtet, der Trägerfilm oder die Folie entfernt, und die gehärtete Unterlage ist für die stromlose Metallisierung vorbereitet. Die speziellen Verfahren zur stromlosen Plattierung sind nicht Gegenstand der Erfindung. Im allgemeinen wird die gehärtete Klebstoffoberfläche der isolierenden Unterlage vor der Metallabscheidung geätzt, sensibilisiert und dgl. Es ist auch bekannt, daß der Klebstoff selbst verschiedene Zusätze, beispielsweise Keime enthalten kann, die die Plattierung erleichtern.

Beispiel:

Der Nitril/Phenol/Kunstharzkleber BR-238 wird mit Methyläthylketon und Methylisobutylketon (1:4) gemischt unter Erhalt einer Lösung mit 10 bis 20 Gew.% Feststoffgehalt. Die Klebstofflösung wird auf einen Polyvinylfluoridfilm (Tedlar von DuPont) unter Verwendung einer Ziehstange aufgetragen. Der beschichtete Film wird 30 Minuten lang auf 65,6° C erhitzt, um das Lösungsmittel zu verdampfen unter Zurücklassung einer Klebstoffschicht mit einer Schichtdicke von 0,0076 bis 0,021 mm.

Dann wird der mit dem Klebstoff beschichtete Film mit der Oberfläche einer mit einem Epoxidharz behandelten Unterlage aus Glasfaserlaminat in Kontakt gebracht. Das Epoxidharz ist im wesentlichen ungehärtet. Das Laminat, in dem der Klebstoff mit der Unterlage in Kontakt ist, wird eine Stunde lang bei einem Druck von 345,31 N/cm$^2$ (500 psi) auf 171° C erhitzt. Anschließend wird der Tedlarfilm von dem Laminat abgeschält unter Freilegung der gehärteten Klebstoffschicht, die nunmehr integraler Bestandteil der Unterlage ist. Im Anschluß an eine Ätzung mit Chromschwefelsäure, der Sensibilisierung und der Anordnung eines Resistmusters wird eine stromlose Metallisierung durchgeführt. Durch die nachfolgende Entfernung des Photoresists wird eine gedruckte Schaltkreisplatte erhalten. Nach dem Härten kann ein Bohren von Löchern in oder durch die mit Klebstoff beschichtete Unterlage erfolgen.

- 10 -

<u>P A T E N T A N S P R Ü C H E</u>

1. Verfahren zur stromlosen Metallisierung einer isolierenden Unterlage,

   dadurch gekennzeichnet,

   daß ein Übertragungsmaterial mit einem nicht gehärteten hitzehärtbaren Nitrilkautschuk/Phenolkunstharzkleber beschichtet, die beschichtete Oberfläche des Übertragungsmaterials mit der Oberfläche einer isolierenden Unterlage in Kontakt gebracht und die Schichtstruktur zur Härtung des Kunstharzklebers erhitzt wird, daß anschließend das Übertragungsmaterial entfernt und in an sich bekannter Weise durch stromloses Plattieren ein Metall auf der Oberfläche der auf der isolierenden Unterlage verbleibenden Kunstharzklebeschicht abgeschieden wird.

2. Verfahren nach Anspruch 1,

   dadurch gekennzeichnet,

   daß die isolierende Unterlage mit einem nicht gehärteten Epoxidharz imprägniert wird.

3. Verfahren nach den Ansprüchen 1 und 2,

   dadurch gekennzeichnet,

   daß der Kunstharzkleber gleichzeitig mit dem Epoxidharz ausgehärtet und dadurch integral mit der imprägnierten Unterlage verbunden wird.

4. Verfahren nach Anspruch 1,

   dadurch gekennzeichnet,

   daß der Kunstharzkleber in Form einer Lösung in Methyläthylketon oder Methylisobutylketon auf das Übertragungsmaterial aufgetragen und das Lösungsmittel vor dem in Kontaktbringen mit der isolierenden Unterlage verdampft wird.

EN 978 017

5. Verfahren nach den Ansprüchen 1 und 4,
dadurch gekennzeichnet,
daß der Kunstharzkleber in einer Schichtdicke von
0,0076 bis 0,021 mm auf das Übertragungsmaterial aufgetragen wird.

6. Verfahren nach einem oder mehreren der Ansprüche 1
bis 5,
dadurch gekennzeichnet,
daß als Übertragungsmaterial ein beschichtetes Papier,
ein Kunststoffilm oder eine Metallfolie und als isolierende Unterlage ein Glasfasergewebe verwendet wird.

7. Verfahren nach Anspruch 6,
dadurch gekennzeichnet,
daß als Übertragungsmaterial ein Film aus Polyäthylen,
Polyvinylchlorid, Polyester, Polypropylen, Polyoxymethylen und vorzugsweise Polyvinylfluorid angewendet
wird.

8. Verfahren nach einem oder mehreren der Ansprüche 1
bis 7,
dadurch gekennzeichnet,
daß das Übertragungsmaterial von der Kunstharzklebeschicht abgeschält oder abgeätzt wird.

9. Verfahren nach den Ansprüchen 1 und 8,
dadurch gekennzeichnet,
daß auf der Kunstharzklebeschicht nach der Entfernung
des Übertragungsmaterials und vor der stromlosen Metallisierung ein Photoresistmuster angeordnet wird.

EN 978 017